# EUROPÄISCHE PATENTSCHRIFT

(11) **EP 3 507 841 B1**
(45) Veröffentlichungstag und Bekanntmachung des Hinweises auf die Patenterteilung: **17.06.2020**
(21) Anmeldenummer: 17757484.5
(22) Anmeldetag: 10.08.2017
(51) Int. Cl.: H01L 41/09, H01L 41/04

(54) **WANDLEREINRICHTUNG**
TRANSDUCER DEVICE
MOYENS TRANSDUCTEURS

(30) Priorität: 31.08.2016 DE 102016216365
(43) Veröffentlichungstag der Anmeldung: 10.07.2019
(73) Patentinhaber: Robert Bosch GmbH, 70442 Stuttgart (DE)
(72) Erfinder: DENES, Istvan, 71277 Rutesheim (DE)
(86) Internationale Anmeldenummer: PCT/EP2017/070266
(87) Internationale Veröffentlichungsnummer: WO 2018/041580

(56) Entgegenhaltungen:
- EP-A2- 2 463 926
- US-A1- 2006 208 609
- US-A1- 2012 055 257
- US-A1- 2014 247 231

## Beschreibung

### Stand der Technik

Die Erfindung betrifft eine Wandlereinrichtung nach dem Oberbegriff des Anspruchs 1.

Eine derartige Wandlereinrichtung zum Einsatz in einem Kraftfahrzeug ist aus der DE 10 2013 216 599 A1 der Anmelderin bekannt. Die bekannte Wandlereinrichtung umfasst ein elektroaktives Polymerelement (Polymerwandler), das mit einer Spannungsquelle verbindbar ist. Die Spannungsquelle umfasst, obwohl in der Schrift nicht explizit offenbart, eine elektronische Schaltung, die dazu ausgebildet ist, die (12V-) Bordspannung des Kraftfahrzeugs ausgangsseitig auf eine an dem Polymerwandler anliegende Spannung von mehr als 50V zu transformieren, da eine derartige Spannung erforderlich ist, um den Polymerwandler sinnvoll zu betreiben bzw. relativ große Hübe erzeugen zu können. Dabei ist wesentlich, dass der Polymerwandler und die elektronische Schaltung als getrennte Baueinheiten ausgebildet sind, die miteinander verbunden sind. Problematisch dabei ist, dass Spannungsquellen, die beispielsweise mehr als 50V Nennspannung aufweisen, bei einer Berührung durch einen Menschen für diesen potentiell gefährlich sind. Daher sind spezielle Sicherungsmaßnahmen erforderlich, um einen direkten (menschlichen) Kontakt mit der Spannungsquelle zu vermeiden. Darüber hinaus können Schaltungen mit derartig hohen Spannungen feldgebundene Störungen in der Umgebung verursachen, die den Betrieb des Kraftfahrzeugs beeinflussen, sodass zusätzliche, den vorrichtungstechnischen Aufwand erhöhende Maßnahmen zur elektromagnetischen Verträglichkeit (EMV) der Wandlereinrichtung getroffen werden müssen.

Diesbezüglich ist aus der US 2014/247231 A1 eine Wandlereinrichtung mit einem elektroaktiven Polymerwandler bekannt, der wenigstens zwei parallel zueinander angeordnete Elektrodenschichten aufweist.

Neue Beschreibungsseite 1a mit markierten Änderungen Auch aus der US 2012/055257 A1 ist ein gattungsgemäßer Wandler bekannt. Weiterhin ist aus der EP 2463926 A2 die Verwendung einer laminierten Struktur aus einem elektroaktiven Polymer und einer Vielzahl von Elektroden bekannt. Darüber hinaus offenbart das Dokument US20060208609 einen elektroaktiven Polymeraktor mit einem Gewichtselement (siehe Abb. 15 und 19B).

### Offenbarung der Erfindung

Die Wandlereinrichtung mit den Merkmalen des Anspruchs 1 hat den Vorteil, dass sie hinsichtlich einer potentiellen Gefährdung mit der Ausgangsspannung der elektronischen Schaltung insofern unkritisch ist, dass ein direkter Kontakt mit der Spannungsversorgung des Polymerwandlers konstruktiv ausgeschlossen ist.

Der Erfindung liegt die Idee zugrunde, die elektronische Schaltung zur Spannungsversorgung des Polymerwandlers zusammen mit dem Polymerwandler in Form einer gemeinsamen Baueinheit auszubilden, bei der die Kontaktstellen der elektronischen Schaltung zu bzw. an den Elektrodenschichten des Polymerwandlers elektrisch isoliert sind, und wobei die Bauteile der elektronischen Schaltung zumindest teilweise zwischen mehreren, elektrisch isolierenden Schichten aufgenommen und von den Schichten vorzugsweise umhüllt sind. Eine derartige Ausbildung der Wandlereinrichtung ermöglicht es, die spannungsführenden und beim direkten Kontakt mit einer Person kritischen Kontaktstellen bzw. Bauteile elektrisch isoliert anzuordnen, sodass ein entsprechender Kontakt mit einer Person nicht möglich ist.

Wesentlich im Rahmen der Erfindung ist es, dass die Bauart bzw. Anordnung der einzelnen Elektrodenschichten des Polymerwandlers, sei es in Form eines Membranelements oder in Form eines Stapelaktuators, unabhängig von der Grundidee der Erfindung ist und bei allen denkbaren Anordnungen bzw. Ausbildungen der Elektrodenschichten grundsätzlich realisierbar ist.

Vorteilhafte Weiterbildungen der erfindungsgemäßen Wandlereinrichtung sind in den Unteransprüchen aufgeführt.

In einer ersten konstruktiven Ausgestaltung der Wandlereinrichtung ist es vorgesehen, dass zur Befestigung des Polymerwandlers ein Trägerelement dient, wobei das Trägerelement aus mehreren Schichten besteht, zwischen denen die Bauteile der elektronischen Schaltung zumindest teilweise sandwichartig aufgenommen sind, und wobei das Trägerelement gleichzeitig der elektrischen Kontaktierung der Elektrodenschichten dient bzw. die Kontaktierung umgibt. Da die Kontaktierung in diesem Fall innerhalb des Trägerelements bzw. zwischen den einzelnen, elektrisch isolierenden Schichten des Trägerelements erfolgt, ist ein isolierter Anbau des Polymerwandlers an dem Trägerelement auf besonders einfache Art und Weise möglich.

Die Schichten des Trägerelements, die vorzugsweise aus einem geeigneten Kunststoff wie Polymid, Polykarbonat oder aus einem Kunststoff auf Polyesterbasis bestehen, weisen typischerweise eine Schichtdicke von etwa jeweils einigen Zehntel Millimeter auf, sodass insgesamt gesehen das Trägerelement, je nach Anzahl und Dicke der einzelnen Schichten und deren Material, flexibel ausgestaltet sein kann. Damit lässt sich insbesondere ein besonders einfacher An- bzw. Einbau der Wandlereinrichtung an einem Aggregat o.ä. ermöglichen.

Weiterhin sieht die erste konkrete konstruktive Ausgestaltung des Polymerwandlers in einer Weiterbildung vor, dass der Polymerwandler eine ringförmig ausgebildete Membran aufweist, die in einem zentralen Bereich von einem Gewichtelement belastet ist, das bewirkt, dass der ringförmige Bereich der Membran in einem Winkel zu dem Trägerelement angeordnet und gleichzeitig parallel zum Trägerelement ausgerichtet ist. Bei einer Beaufschlagung des Polymerwandlers dehnt sich dadurch beispielsweise die Membran aus, derart, dass sich der Abstand des zentralen Bereichs vom Trägerelement vergrößert, wobei die Abstandsvergrößerung dem Ankerhub des Wandlerelements entspricht.

In einer alternativ vorgesehenen Ausgestaltung der Wandlereinrichtung, bei der der Polymerwandler in Form eines Stapelwandlers ausgebildet ist, weist der Polymerwandler eine Vielzahl von parallel zueinander angeordneten Elektrodenschichten auf, wobei die jeweils äußerste Elektrodenschicht des Elektrodenstapels auf einander abgewandten Seiten von jeweils einer als Kraftübertragungselement ausgebildeten Endkappe überdeckt ist, und wobei wenigstens eine der Endkappen mehrere Schichten zur Aufnahme der elektronischen Schaltung aufweist. Es kann somit vorgesehen sein, dass die eine Endkappe die elektronische Schaltung aufnimmt und gleichzeitig mit einer Trägerstruktur oder Ähnlichem (ortsfest) verbunden ist, während die andere Endkappe mit dem zu verstellenden Element verbunden ist.

Unabhängig von der konkreten konstruktiven Ausgestaltung des Polymerwandlers ist es bevorzugt vorgesehen, dass die Bauelemente bzw. Bauteile der elektronischen Schaltung wenigstens teilweise in einer Ausnehmungen für die Bauteile der elektronischen Schaltung aufweisenden Schicht aufgenommen sind, die beidseitig von anderen Schichten überdeckt ist. Dadurch lässt sich insbesondere ein besonders geschützter Einbau bzw. eine besonders geschützte Anordnung der Bauelemente in der die Aussparungen aufweisenden Schicht erzielen, wobei gleichzeitig beim Übereinanderlegen und Verbinden der einzelnen Schichten durch einen Laminierprozess erfolgen kann.

Es können Bauelemente in der elektronischen Schaltung vorgesehen sein, deren Dicke derart groß ist, dass diese nicht ohne eine nicht erwünschte Vergrößerung der Schichtdicke der die Bauelemente aufnehmenden Schicht angeordnet werden können. In diesem Fall sieht eine Weiterbildung der Erfindung vor, dass wenigstens ein Bauelement der elektronischen Schaltung an einer Außenseite einer äußeren Schicht angeordnet und mit dieser verbunden ist, und dass das Bauelement von einer elektrischen Isoliermasse zumindest teilweise umschlossen ist. Eine derartige, durch ein Harz, ein Elastomer oder ein ähnliches Material ausgebildete Verkapselung des äußeren Bauelements ermöglicht es, die Anzahl bzw. Gesamtdicke der Schichten möglichst gering zu halten, wobei das (äußere) elektronische Bauelement trotzdem vor Umgebungseinflüssen und gegen direkten Kontakt geschützt angeordnet ist.

Je nach Anbauort bzw. konstruktiver Ausgestaltung des Polymerwandlers und der elektronischen Schaltung kann es darüber hinaus von Vorteil sein, wenn die Bauelemente der elektronischen Schaltung teilweise von einer metallischen Schicht zur Erzeugung einer elektromagnetischen Abschirmeinrichtung überdeckt sind.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine vereinfachte Unteransicht auf eine Wandlereinrichtung mit einem eine rechteckförmige Grundfläche aufweisenden Trägerelement.
- Fig. 2: eine Seitenansicht auf die Wandlereinrichtung gemäß Fig. 1,
- Fig. 3: ein Detail der Fig. 2 in einer vergrößerten Darstellung,
- Fig. 4: ein gegenüber Fig. 3 abgewandeltes Detail, bei der ein Bauelement einer elektronischen Schaltung auf einer Oberseite einer Schicht angeordnet ist,
- Fig. 5: ein gegenüber Fig. 3 abgewandeltes Detail unter Verwendung einer metallischen Abschirmschicht und
- Fig. 6: eine Wandlereinrichtung in Form eines Stapelaktuators in einem vereinfachten Längsschnitt.

Gleiche Elemente bzw. Elemente mit gleicher Funktion sind in den Figuren mit den gleichen Bezugsziffern versehen.

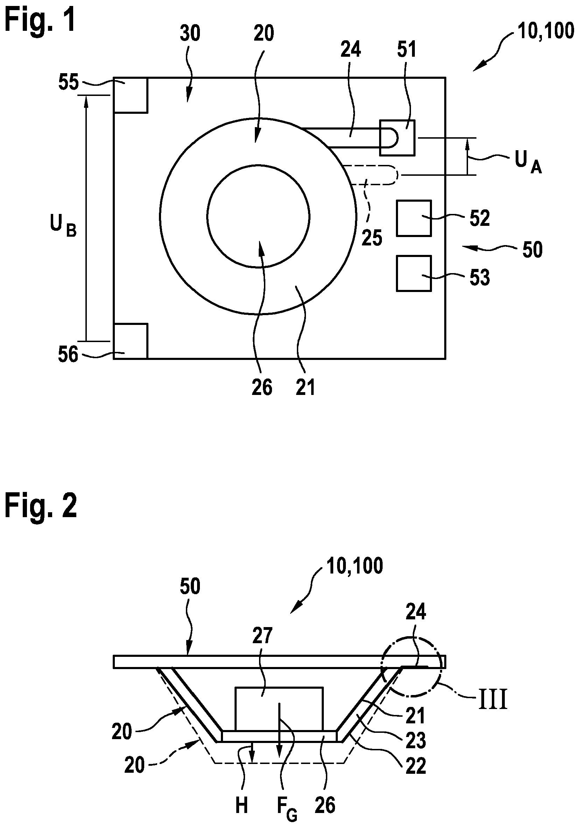

In den Fig. 1 bis 3 ist eine Wandlereinrichtung 10 stark vereinfacht dargestellt. Die Wandlereinrichtung 10 umfasst einen elektroaktiven Polymerwandler 20 und eine der Spannungsversorgung und Ansteuerung des Polymerwandlers 20 dienende elektronischen Schaltung 50, die eine gemeinsame Baueinheit 100 ausbilden.

Der Polymerwandler 20 umfasst wenigstens zwei, mit unterschiedlichen Polen der elektronischen Schaltung 50 verbindbare, flexible Elektrodenschichten 21, 22, zwischen denen eine in Form eines Dielektrikums ausgebildete, elastische Zwischenschicht 23 angeordnet ist. Insgesamt gesehen ist der Polymerwandler 20 membranartig ausgebildet. Die beiden Elektrodenschichten 21, 22 weisen jeweils mit diesen verbundene Anschlussbereiche 24, 25 auf, die mit unterschiedlichen Polen einer Spannungsquelle verbunden sind, die durch die elektronische Schaltung 50 ausgebildet ist. Die beiden Elektrodenschichten 21, 22 sind ebenso wie die Zwischenschicht 23 in Draufsicht jeweils in etwa ringförmig ausgebildet, wobei die beiden Elektrodenschichten 21, 22 sowie die Zwischenschicht 23 fluchtend zueinander angeordnet sind und parallel zueinander verlaufen. In einem zentralen, ebenen Bereich 26 des Polymerwandlers 20 ist dieser von einem Gewichtselement 27 kraftbeaufschlagt, dessen Gewichtskraft F_{G} senkrecht zum zentralen Bereich 26 wirkt. Auf der dem zentralen Bereich 26 abgewandten Seite sind die umfangsseitig angeordneten Randbereiche des Polymerwandlers 20 mit einem Trägerelement 30 verbunden. Die Elektrodenschichten 21, 22 und die Zwischenschicht 23 verlaufen in einem schrägen Winkel zum Trägerelement 30.

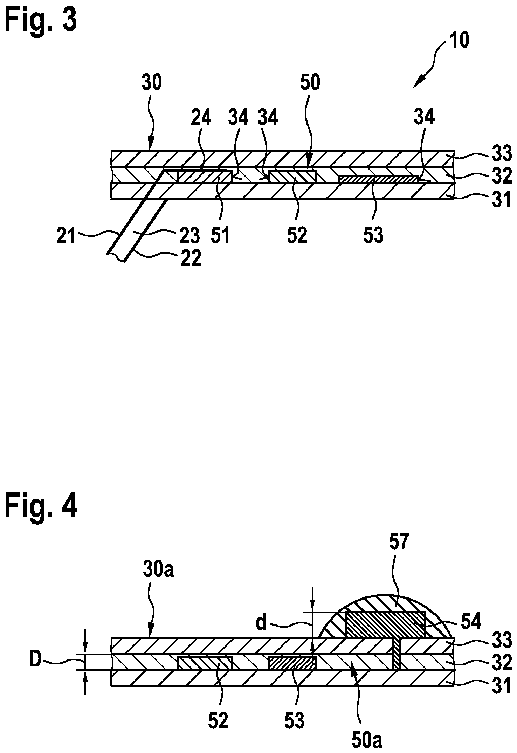

Das Trägerelement 30 besteht, wie insbesondere anhand der Fig. 3 erkennbar ist, beispielhaft aus drei miteinander verbundenen, aus Kunststoff bestehenden (flexiblen) Schichten 31 bis 33, die sandwichartig übereinander angeordnet und vorzugsweise durch einen Laminierprozess miteinander verbunden sind. Die zwischen den beiden Schichten 31, 33 angeordnete (mittlere) Schicht 32 weist darüber hinaus Vertiefungen, Ausnehmungen 34 o.ä. zur Aufnahme von elektronischen Bauteilen 51 bis 53 auf, die Bestandteil der elektronischen Schaltung 50 sind bzw. diese ausbilden.

Die Bauelemente 51 bis 53 können unterschiedliche Größen und/oder Dicken oder Flächen aufweisen, wobei jedoch wesentlich ist, dass jedes der Bauelemente 51 bis 53 innerhalb einer Ausnehmung 34 angeordnet ist. Beispielhaft dient das eine Bauelement 51 der elektrischen Verbindung mit dem einen Anschlussbereich 24, wobei anstelle eines Bauelements 51 selbstverständlich auch ein elektrisch leitender Kontaktbereich vorgesehen sein kann, der mit der Schaltung 50 verbunden ist. Hierzu sind zumindest in der einen Schicht 31 entsprechende Durchführungen (nicht dargestellt) für die Anschlussbereiche 24, 25 ausgebildet. An den beiden Anschlussbereichen 24, 25 des Polymerwandlers 20 liegt die von der Schaltung 50 erzeugte Ausgangsspannung U_{A} zur Ansteuerung des Polymerwandlers 20 an, wobei die Ausgangsspannung U_{A} insbesondere mehr als 50V beträgt.

Das Trägerelement 30 weist weiterhin beispielhaft an Eckbereichen zwei, mit der elektronischen Schaltung 50 auf nicht gezeigte Art und Weise verbundene Anschlusselemente 55, 56 auf, an denen eine Spannungsversorgung anlegbar ist, insbesondere in Form einer Bordspannung U_{B} eines Kraftfahrzeugs. Dabei beträgt die Nennspannung der Bordspannung U_{B} beispielsweise 12V. Die elektronische Schaltung 50 wirkt daher in Art eines Trafos zur Spannungserhöhung.

Bei einer Bestromung des Polymerwandlers 20 durch die elektronische Schaltung 50 wird zwischen den beiden Elektrodenschichten 21, 22 eine Anziehungskraft erzeugt, so dass sich deren gegenseitigen Abstand zueinander verringert. Dies bewirkt, dass sich die Elektrodenschichten 21, 22 zusammen mit der Zwischenschicht 23 aufgrund der Volumenkonstanz in ihrer senkrecht jeweiligen Schicht verlaufenden Richtung ausdehnen. Dies wiederum bewirkt, dass entsprechend der gestrichelten Darstellung in der Fig. 2 der zentrale Bereich 26 des Polymerwandlers 20 um einen Ankerhub H in einer senkrecht zum Trägerelement 30 verlaufenden Richtung ausgelenkt wird, um beispielsweise ein Element oder Ähnliches zu verstellen.

Wesentlich ist, dass sowohl die Anschlussbereiche 24, 25 der Elektrodenschichten 21, 22, als auch die Elemente der Schaltung 50, an denen die Ausgangsspannung U_{A} für die Elektrodenschichten 21, 22 anliegt, elektrisch gegenüber der Umgebung isoliert angeordnet sind.

In der Fig. 4 ist ausschnittsweise ein gegenüber der Fig. 3 modifiziertes Trägerelement 30a dargestellt. Bei dem Trägerelement 30a ist ein Bauelement 54 der elektronischen Schaltung 50a aufgrund seiner Dicke d, die größer ist als die Dicke D der (mittleren) Schicht 32, an der Oberseite der Schicht 33 angeordnet bzw. befestigt. Das Bauelement 54 ist mit einem Medium, beispielsweise einem Elastomer 57 verkapselt, wobei das Elastomer 57 elektrisch isolierende Eigenschaften aufweist.

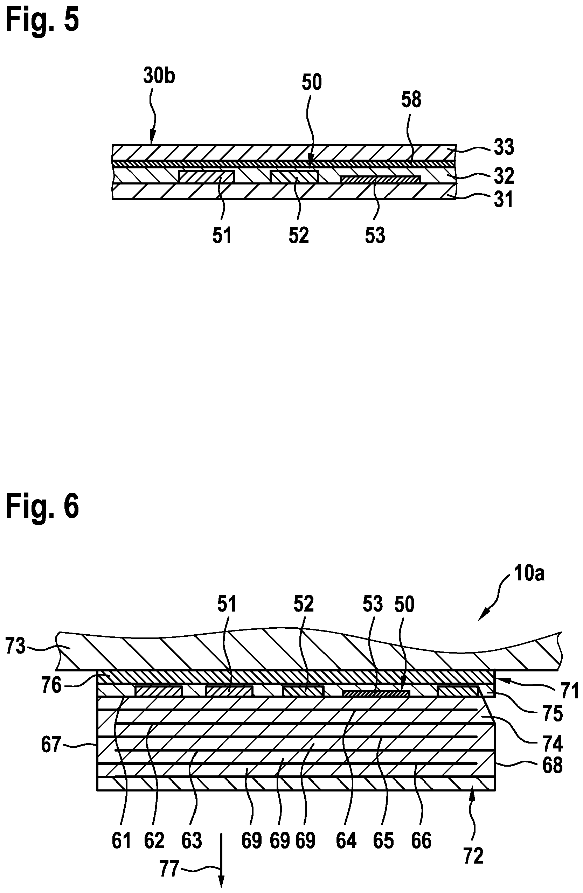

In der Fig. 5 ist ausschnittsweise ein nochmals modifiziertes Trägerelement 30b dargestellt, das sich gegenüber dem Trägerelement 30 gemäß der Fig. 3 dadurch unterscheidet, dass zwischen den beiden Schichten 32 und 33 eine aus Metall bestehende Schicht 58 angeordnet ist, die die elektronische Schaltung 50 bzw. deren Bauelemente 51 bis 53 auf der der Schicht 31 abgewandten Seite überdeckt, und wobei die Schicht 58 als Abschirmfolie zur Verbesserung der elektromagnetischen Eigenschaften der elektronischen Schaltung 50 dient. Die Schicht 58 bzw. Folie ist insbesondere auf Kupfer-, Aluminium- oder Eisenbasis hergestellt und im Trägerelement 30b einlaminiert.

Die in der Fig. 6 dargestellte und außerhalb des Schutzbereichs der beanspruchten Erfindung liegende Wandlereinrichtung 10a weist eine Vielzahl von übereinander gestapelten, und mit unterschiedlichen Polen der Ausgangsspannung U_{A} der elektronischen Schaltung 50 verbundenen Elektrodenschichten 61 bis 63 sowie 64 bis 66 auf. Die einzelnen Elektrodenschichten 61 bis 63 bzw. 64 bis 66 sind jeweils mit einer gemeinsamen Seitenkontaktierung 67, 68 elektrisch leitend verbunden. Zwischen den einzelnen Elektrodenschichten 61 bis 66 sind darüber hinaus elastische Zwischenschichten 69 angeordnet. Die beiden äußeren Elektrodenschichten 61 und 66 sind jeweils mit einer Endkappe 71, 72 verbunden, wobei die eine Endkappe 71 beispielhaft mit einer Trägerstruktur 73 und die andere Endkappe 72 mit einem zu verstellenden Element (nicht dargestellt) verbunden sind. Im Bereich der einen Endkappe 71 ist darüber hinaus die elektronische Schaltung 50 angeordnet bzw. aufgenommen. Hierzu besteht die Endkappe 71 in Analogie zu den Trägerelementen 30, 30a, 30b aus mehreren, miteinander verbundenen Schichten 74 bis 76, wobei beispielhaft in der mittleren Schicht 75 die Bauelemente 51 bis 53 der elektronischen Schaltung 50 angeordnet bzw. aufgenommen sind, und wobei die elektronische Schaltung 50 über die Seitenkontaktierungen 67, 68 mit den Elektrodenschichten 61 bis 66 verbunden sind.

Bei einer Ansteuerung der Elektrodenschichten 61 bis 66 wird die eine Endkappe 72, die mit dem zu verstellenden Element verbunden ist, aus der in der Fig. 6 gezeigten Position in Richtung des Pfeils 77 bewegt.

Die soweit beschriebenen Wandlereinrichtungen 10, 10a können in vielfältiger Art und Weise abgewandelt bzw. modifiziert werden, ohne vom Erfindungsgedanken abzuweichen.

## Patentansprüche

1. Wandlereinrichtung (10) mit einem elektroaktiven Polymerwandler (20), der wenigstens zwei parallel zueinander angeordneten Elektrodenschichten (21, 22) aufweist, die unter Zwischenlage jeweils einer elastischen Zwischenschicht (23) miteinander verbunden sind, und mit einer elektronische Bauelemente (51 bis 54) aufweisenden Schaltung (50; 50a) zur Erzeugung einer an den Elektrodenschichten (21, 22) des Polymerwandlers (20) anliegenden elektrischen Spannung (U_{A}), wobei die Schaltung (50; 50a) derart gestaltet ist, dass eine Eingangsspannung (U_{B}) auf die gegenüber der Eingangsspannung (U_{B}) erhöhte Spannung (U_{A}) erhöht wird, wobei die Schaltung (50; 50a) zumindest teilweise zwischen mehreren elektrisch isolierenden Schichten (31 bis 34) aufgenommen und von den Schichten (31 bis 34) vorzugsweise umhüllt ist, wobei die Schaltung (50; 50a) zusammen mit dem Polymerwandler (20) eine gemeinsame Baueinheit (100) ausbildet, bei der die Bereiche, an denen die elektrische Spannung (U_{A}) der Schaltung (50; 50a) zur Spannungsversorgung des Polymerwandlers (20) anliegt, elektrisch isoliert sind, wobei ein Trägerelement (30, 30a, 30b) zur Befestigung des Polymerwandlers vorgesehen ist, wobei die Elektrodenschichten (21, 22) und die Zwischenschicht (23) des Polymerwandlers (20) ringförmig ausgebildet sind, und wobei in einem zentralen Bereich (26) des Polymerwandlers (20) ein Gewichtselement (27) angeordnet ist, das den zentralen Bereich (26) parallel und beabstandet zum Trägerelement (30; 30a) ausrichtet.

2. Wandlereinrichtung nach Anspruch 1,
**dadurch gekennzeichnet,**
**dass** die mehreren elektrisch isolierenden Schichten (31 bis 34) durch das Trägerelement (30; 30a; 30b) gebildet sind.

3. Wandlereinrichtung nach Anspruch 2,
**dadurch gekennzeichnet,**
**dass** das Trägerelement (30; 30a; 30b) flexibel ausgebildet ist.

4. Wandlereinrichtung nach einem der Ansprüche 1 bis 3, **dadurch gekennzeichnet,**
**dass** die Bauelemente (51 bis 54) der Schaltung (50; 50a) wenigstens teilweise in einer wenigstens eine Ausnehmung (34) für die Bauelemente (51 bis 54) aufweisenden Schicht (32) aufgenommen sind, die beidseitig von anderen Schichten (31, 33) überdeckt ist.

5. Wandlereinrichtung nach einem der Ansprüche 1 bis 4, **dadurch gekennzeichnet,**
**dass** wenigstens ein Bauelement (54) der Schaltung (50a) an einer Außenseite einer äußeren Schicht (31) angeordnet und mit dieser verbunden ist, und dass das wenigstens eine Bauelement (54) von einem elektrisch isolierende Eigenschaften aufweisenden Element (57) zumindest teilweise umschlossen ist.

6. Wandlereinrichtung nach einem der Ansprüche 1 bis 5, **dadurch gekennzeichnet,**
**dass** die Bauelemente (51 bis 53) der Schaltung (50) zumindest teilweise von einer metallischen Schicht (58) überdeckt sind.

7. Wandlereinrichtung nach einem der Ansprüche 1 bis 6, **dadurch gekennzeichnet,**
**dass** die Schichten (31 bis 34; 74 bis 76) zur Aufnahme der Schaltung (50; 50a) durch einen Laminierprozess miteinander verbunden sind.

8. Wandlereinrichtung nach einem der Ansprüche 1 bis 7, **dadurch gekennzeichnet,**
**dass** die Schaltung (50; 50a) dazu ausgebildet ist, eine Spannung (U_{A}) für die Elektrodenschichten (21, 22; 61 bis 66) von mehr als 50V zu erzeugen.

9. Wandlereinrichtung nach einem der Ansprüche 1 bis 8,
**dadurch gekennzeichnet,**
**dass** die Schichten (31 bis 34) zur Aufnahme der Schaltung (50; 50a) Polymid (PI), Polykarbonat (PC) oder einen Kunststoff auf Polyesterbasis (PE) aufweisen .

## Claims

1. Transducer device (10) having an electroactive polymer transducer (20) that has at least two electrode layers (21, 22) arranged in parallel with one another and that are connected to one another through the interposition of a respective elastic intermediate layer (23), and having a circuit (50; 50a), which has electronic components (51 to 54), for generating a voltage (U_{A}) present at the electrode layers (21, 22) of the polymer transducer (20), wherein the circuit (50; 50a) is designed such that an input voltage (U_{B}) is boosted to the voltage (U_{A}) that is higher than the input voltage (U_{B}) ,
wherein the circuit (50; 50a) is at least partly received between a plurality of electrically insulating layers (31 to 34) and is preferably surrounded by the layers (31 to 34), wherein the circuit (50; 50a), together with the polymer transducer (20), forms a common structural unit (100) in which the regions at which the voltage (U_{A}) of the circuit (50; 50a) for supplying voltage to the polymer transducer (20) is present are electrically insulated, wherein a carrier element (30, 30a, 30b) is provided for attachment of the polymer transducer, wherein the electrode layers (21, 22) and the intermediate layer (23) of the polymer transducer (20) are designed in a ring shape, and wherein a weighted element (27) is arranged in a central region (26) of the polymer transducer (20) and aligns the central region (26) parallel to and at a distance from the carrier element (30; 30a).

2. Transducer device according to Claim 1,
**characterized in that**
the plurality of electrically insulating layers (31 to 34) are formed by the carrier element (30; 30a; 30b).

3. Transducer device according to Claim 2,
**characterized in that**
the carrier element (30; 30a, 30b) has a flexible design.

4. Transducer device according to one of Claims 1 to 3,
**characterized in that**
the components (51 to 54) of the circuit (50; 50a) are at least partly received in a layer (32) having at least one recess (34) for the components (51 to 54) and that is covered on both sides by other layers (31, 33).

5. Transducer device according to one of Claims 1 to 4,
**characterized in that**
at least one component (54) of the circuit (50a) is arranged on and connected to an outer side of an outer layer (31), and **in that** the at least one component (54) is at least partly enclosed by an element (57) having electrically insulating properties.

6. Transducer device according to one of Claims 1 to 5,
**characterized in that**
the components (51 to 53) of the circuit (50) are at least partly covered by a metal layer (58).

7. Transducer device according to one of Claims 1 to 6,
**characterized in that**
the layers (31 to 34; 74 to 76) for receiving the circuit (50; 50a) are connected to one another through a lamination process.

8. Transducer device according to one of Claims 1 to 7,
**characterized in that**
the circuit (50; 50a) is designed to generate a voltage (U_{A}) of more than 50 V for the electrode layers (21, 22; 61 to 66).

9. Transducer device according to one of Claims 1 to 8,
**characterized in that**
the layers (31 to 34) for receiving the circuit (50; 50a) comprise polyimide (PI), polycarbonate (PC) or a polyester (PE)-based plastic.

## Revendications

1. Dispositif transducteur (10), comprenant un convertisseur polymère électroactif (20) présentant au moins deux couches d'électrodes (21, 22) disposées en parallèle les unes par rapport aux autres et reliées les unes aux autres par interposition d'une couche intermédiaire élastique (23) respectivement, et comprenant un circuit (50 ; 50a) présentant des composants électroniques (51 à 54) pour produire une tension électrique (U_{A}) appliquée aux couches d'électrodes (21, 22) du convertisseur polymère (20), dans lequel le circuit (50 ; 50a) est configuré de telle sorte qu'une tension d'entrée (U_{B}) est augmentée jusqu'à la tension (U_{A}) augmentée par rapport à la tension d'entrée (U_{B}), dans lequel le circuit (50 ; 50a) est reçu au moins en partie entre plusieurs couches électriquement isolantes (31 à 34) et est de préférence enveloppé par les couches (31 à 34), dans lequel le circuit (50 ; 50a) réalise avec le convertisseur polymère (20) une unité modulaire commune (100) dans laquelle les zones où la tension électrique (U_{A}) du circuit (50 ; 50a) est appliquée pour l'alimentation en tension du convertisseur polymère (20) sont électriquement isolées, un élément de support (30, 30a, 30b) étant prévu pour fixer le convertisseur polymère, dans lequel les couches d'électrodes (21, 22) et la couche intermédiaire (23) du convertisseur polymère (20) sont réalisées de manière annulaire, et dans lequel, dans une zone centrale (26) du convertisseur polymère (20), un élément de poids (27) est disposé qui oriente la zone centrale (26) en parallèle et à distance de l'élément de support (30 ; 30a).

2. Dispositif transducteur selon la revendication 1, **caractérisé en ce que** les plusieurs couches électriquement isolantes (31 à 34) sont formées par l'élément de support (30 ; 30a ; 30b).

3. Dispositif transducteur selon la revendication 2, **caractérisé en ce que** l'élément de support (30 ; 30a ; 30b) est réalisé de manière flexible.

4. Dispositif transducteur selon l'une quelconque des revendications 1 à 3, **caractérisé en ce que** les composants (51 à 54) du circuit (50 ; 50a) sont reçus au moins en partie dans au moins un évidement (34) pour la couche (32) présentant les composants (51 à 54) qui est recouverte par d'autres couches (31, 33) des deux côtés.

5. Dispositif transducteur selon l'une quelconque des revendications 1 à 4, **caractérisé en ce qu'**au moins un composant (54) du circuit (50a) est disposé sur une face extérieure d'une couche extérieure (31) et est relié à celle-ci, et **en ce qu'**au moins un composant (54) est entouré au moins en partie par un élément (57) présentant des propriétés d'isolation électrique.

6. Dispositif transducteur selon l'une quelconque des revendications 1 à 5, **caractérisé en ce que** les composants (51 à 53) du circuit (50) sont au moins en partie recouverts d'une couche métallique (58).

7. Dispositif transducteur selon l'une quelconque des revendications 1 à 6, **caractérisé en ce que** les couches (31 à 34 ; 74 à 76) sont reliées les unes aux autres pour recevoir le circuit (50 ; 50a) par un processus de laminage.

8. Dispositif transducteur selon l'une quelconque des revendications 1 à 7, **caractérisé en ce que** le circuit (50 ; 50a) est réalisé pour produire une tension (U_{A}) de plus de 50 V pour les couches d'électrodes (21, 22 ; 61 à 66).

9. Dispositif transducteur selon l'une quelconque des revendications 1 à 8, **caractérisé en ce que** les couches (31 à 34) pour recevoir le circuit (50 ; 50a) présentent du polyimide (PI), du polycarbonate (PC) ou une matière plastique à base de polyester (PE).
